# EUROPÄISCHE PATENTSCHRIFT

(11) **EP 3 245 726 B1**
(45) Veröffentlichungstag und Bekanntmachung des Hinweises auf die Patenterteilung: **14.12.2022**
(21) Anmeldenummer: 15710733.5
(22) Anmeldetag: 27.02.2015
(51) Int. Cl.: H02M 7/00, H02M 7/483

(54) **ANORDNUNG MIT EINEM STROMRICHTER**
ARRANGEMENT HAVING A CONVERTER
SYSTÈME COMPORTANT UN CONVERTISSEUR DE PUISSANCE

(43) Veröffentlichungstag der Anmeldung: 22.11.2017
(73) Patentinhaber: Siemens Energy Global GmbH & Co. KG, 81739 München (DE)
(72) Erfinder: DORN, Jörg, 96155 Buttenheim (DE); KNAAK, Hans-Joachim, 91054 Erlangen (DE); SACHS, Günter, 91074 Herzogenaurach (DE)
(86) Internationale Anmeldenummer: PCT/EP2015/054150
(87) Internationale Veröffentlichungsnummer: WO 2016/134786

(56) Entgegenhaltungen:
- EP-A1- 2 254 228
- WO-A1-93/17488
- WO-A1-95/28030
- WO-A1-2014/131456
- WO-A1-2014/131457
- US-A- 3 805 140
- US-A- 6 151 201
- US-A1- 2012 099 273
- H Rebholz ET AL: "Dielektrische Festigkeit verschiedener Gase in GIS", , 9 March 2005 (2005-03-09), XP055675216, Retrieved from the Internet: URL:https://www.ieh.uni-stuttgart.de/dokum ente/publikationen/2005_Gase_Rebholz.pdf [retrieved on 2020-03-10]
- Electric Fuji: "SF 6 Gas Insulated Switchgear Type SDH314 / SDHa314 for 72.5 to 145 kV Typical Arrangement", , 31 March 2013 (2013-03-31), XP055674999, Retrieved from the Internet: URL:https://www.fujielectric.com/products/ transmission_distribution/box/doc/06B1-E-0 002.pdf [retrieved on 2020-03-09]
- P Lips: "COMPACT HVDC CONVERTER STATION DESIGN CONSIDERATIONS Brown, Boveri & Cie., Aktiengesellschaft+ Mannheim, Federal Republic of Germany", IEEE Transactions on Power Apparatus and System, 30 June 1976 (1976-06-30), page 95, XP055224249,

## Beschreibung

Die Erfindung betrifft eine Anordnung mit einem Stromrichter und ein Verfahren zum Beeinflussen von Betriebsbedingungen eines Stromrichters.

Stromrichter sind leistungselektronische Schaltungen zum Umformen von elektrischer Energie. Beispiele für Stromrichter (Power Converter) sind Gleichrichter (Rectifier), Wechselrichter (Power Inverter) oder Wechselstrom-Umrichter (AC/AC-Converter).

Aus der internationalen Patentanmeldung WO 95/28030 A1 ist ein Stromrichter mit gasisolierten leistungselektronischen Ventilen bekannt. Die leistungselektronischen Ventile sind in einem elektrisch leitenden Gehäuse angeordnet, welches Durchführungen für elektrische Leiter aufweist.

Die europäische Patentanmeldung EP 2 254 228 A1 offenbart einen Stromrichter mit luftgekühlten Leistungshalbleitermodulen.

Die internationale Patentanmeldung WO 2014/131456 A1 offenbart eine Umrichterstation mit einem ölisolierten oder gasisolierten Diodengleichrichter, der in einem Kapselungsgehäuse angeordnet ist. An dem Kapselungsgehäuse sind Einlass- und Auslassmittel vorgesehen, über die der Isolierstoff entweichen beziehungsweise eingefüllt werden kann.

Aus der internationalen Patentanmeldung WO 93/17488 A1 ist ein leistungselektronisches Halbleiterventil bekannt, das in einem hermetisch abgeschlossenen Gehäuse angeordnet ist. Das Halbleiterventil ist luftisoliert, wobei die Temperatur, die Feuchtigkeit und der Druck der Luft beeinflusst werden kann.

Die Patentanmeldung US 6,151,201 A offenbart ein gasisoliertes Halbleiterventil, das in einem Metallgehäuse angeordnet ist. Dabei können Druck und Temperatur des Isoliergases beeinflusst werden.

Aus dem Artikel "Dielektrische Festigkeit verschiedener Gase in GIS" von H. Rebholz et al, 9. März 2005, XP055675216, sind verschiedene Gase bekannt, die als Alternative zum Isoliergas SF₆ eingesetzt werden können.

Die Schrift "SF₆ Gas Insulated Switchgear Type SDH314 / SDHa314 for 72.5 to 145 kV" von Fuji Electric, 31. März 2013, offenbart eine mit dem Isoliergas SF₆ isolierte Schaltanlage, die einen Gaseinlass aufweist.

Es sind allgemein Stromrichter bekannt, die mindestens ein Phasenmodul, einen Wechselspannungsanschluss, einen ersten Gleichspannungsanschluss und einen zweiten Gleichspannungsanschluss aufweisen. Zwischen dem Wechselspannungsanschluss und dem ersten Gleichspannungsanschluss ist ein erster Phasenmodulzweig ausgebildet, und zwischen dem Wechselspannungsanschluss und dem zweiten Gleichspannungsanschluss ist ein zweiter Phasenmodulzweig ausgebildet. Jeder Phasenmodulzweig weist mindestens zwei Submodule auf. Durch elektrische Reihenschaltung der Submodule lassen sich hohe Ausgangsspannungen realisieren. Die Submodule weisen jeweils eine Mehrzahl von elektrischen Bauteilen auf. Solche Bauteile können z.B. elektronische Bauelemente sein oder Baugruppen, welche mehrere elektronische Bauelemente aufweisen. Insbesondere können solche Bauteile leistungselektronische Bauteile mit Ventilfunktion sein (also leistungselektronische Bauteile, die den Strom nur in einer Richtung passieren lassen).

Solche Stromrichter waren bisher üblicherweise mit Luftisolierung aufgebaut. Dabei sind die Submodule (und deren elektrische Bauteile) gegeneinander und gegen die Umgebung mittels Luft isoliert. Bei hohen Spannungen sind für diese Luftisolierung ein beträchtlicher Abstand zwischen den einzelnen Submodulen und ein beträchtlicher Abstand zum Gehäuse des Stromrichters hin notwendig, um Spannungsüberschläge zu verhindern. Daher ist für die Realisierung von luftisolierten Stromrichtern ein beträchtlicher Platz notwendig; diese luftisolierten Stromrichter nehmen einen beträchtlichen Raum ein.

Der Erfindung liegt die Aufgabe zugrunde, eine Anordnung sowie ein Verfahren anzugeben, mit denen der für Stromrichter benötigte Platz/Raum verkleinert werden kann.

Diese Aufgabe wird erfindungsgemäß gelöst durch eine Anordnung und durch ein Verfahren nach den unabhängigen Patentansprüchen. Vorteilhafte Ausführungsformen der Anordnung bzw. des Verfahrens sind in den jeweiligen abhängigen Patentansprüchen angegeben.

Offenbart wird eine Anordnung mit einem Stromrichter, der mindestens ein Phasenmodul, einen Wechselspannungsanschluss, einen ersten Gleichspannungsanschluss und einen zweiten Gleichspannungsanschluss aufweist, wobei zwischen dem Wechselspannungsanschluss und dem ersten Gleichspannungsanschluss ein erster Phasenmodulzweig ausgebildet ist, wobei zwischen dem Wechselspannungsanschluss und dem zweiten Gleichspannungsanschluss ein zweiter Phasenmodulzweig ausgebildet ist, und wobei jeder Phasenmodulzweig mindestens zwei Submodule aufweist, wobei die Submodule des ersten Phasenmodulzweigs von einem ersten (gemeinsamen) Gehäuse umgeben sind, welches zur Aufnahme eines gasförmigen Stoffs geeignet ist, und wobei die Submodule des zweiten Phasenmodulzweigs von einem zweiten (gemeinsamen) Gehäuse umgeben sind, welches zur Aufnahme des gasförmigen Stoffs geeignet ist.

Die Submodule des ersten Phasenmodulzweigs sind von dem ersten Gehäuse umgeben, welches zur Aufnahme eines gasförmigen Stoffs geeignet ist, und die Submodule des zweiten Phasenmodulzweigs sind von dem zweiten Gehäuse umgeben, welches zur Aufnahme des gasförmigen Stoffs geeignet ist. Durch Einbringen eines geeigneten gasförmigen Stoffs in das erste Gehäuse und das zweite Gehäuse kann eine höhere Durchschlagfestigkeit pro Längeneinheit erreicht werden als bei Luftisolierung. Dadurch kann der Abstand zwischen den Submodulen bzw. der Abstand zwischen den Submodulen und den Gehäusen verringert werden; der Stromrichter kann also kompakter aufgebaut werden. Dadurch kann der für den Stromrichter benötigte Platz/Raum deutlich verkleinert werden. Ein solcher Stromrichter kann beispielsweise ein sogenannter modularer Multilevel-Umrichter sein.

Die Anordnung kann so ausgestaltet sein, dass der Stromrichter mehrere Phasenmodule, insbesondere drei Phasenmodule (für drei Phasen einer Wechselspannung bzw. eines Wechselstroms), aufweist. Mit jedem Phasenmodul kann eine Phase einer Wechselspannung / eines Wechselstroms umgeformt werden. Mit einem Stromrichter mit drei Phasenmodulen kann also Dreiphasenwechselstrom in Gleichstrom (oder umgekehrt) umgeformt werden. Stromrichter mit mehr als drei Phasenmodulen sind ebenfalls möglich: durch Parallelschaltung von Phasenmodulen kann die Leistung des Stromrichters vergrößert werden.

Die Anordnung kann so ausgestaltet sein, dass die Submodule Halbbrückenmodule und/oder Vollbrückenmodule sind. Insbesondere können die Phasenmodulzweige sowohl Halbbrückenmodule als auch Vollbrückenmodule aufweisen.

Die Anordnung kann dabei so ausgestaltet sein, dass ein Halbbrückenmodul zwei abschaltbare Halbleiterventile mit jeweils einer antiparallel geschalteten Diode und einen Energiespeicher aufweist. Halbbrückenmodule sind aufgrund der geringeren Anzahl von Bauelementen einfacher und kostengünstiger zu realisieren als Vollbrückenmodule.

Die Anordnung kann dabei auch so ausgestaltet sein, dass ein Vollbrückenmodul vier abschaltbare Halbleiterventile mit jeweils einer antiparallel geschalteten Diode und einen Energiespeicher aufweist. Die vier abschaltbaren Halbleiterventile sind dabei in einer sogenannten Brückenschaltung angeordnet. Bei Vollbrückenmodulen kann vorteilhafterweise die von jedem Submodul bereitstellbare Spannung eine beliebige Polarität aufweisen.

Die Anordnung kann dabei so ausgestaltet sein, dass die Anordnung eine Verbindungsleitung (Gas-Verbindungsleitung, Gasleitung) zum (gasbezogenen) Verbinden des ersten Gehäuses mit dem zweiten Gehäuse aufweist. Dadurch kann der gasförmige Stoff einfach in den Gehäusen des Stromrichters verteilt werden.

Die Anordnung kann dabei so ausgestaltet sein, dass die Anordnung eine Absperreinrichtung (Gas-Absperreinrichtung) zum (gasbezogenen) Trennen des ersten Gehäuses von dem zweiten Gehäuse aufweist. Dadurch kann bei Bedarf (z.B. bei Wartungsarbeiten) das erste Gehäuse von dem zweiten Gehäuse getrennt werden. Diese gasbezogene Trennung ermöglicht es, in einem der Gehäuse den gasförmigen Stoff zu verändern, während in dem anderen Gehäuse der gasförmige Stoff unverändert bleibt.

Die Anordnung kann dabei so ausgestaltet sein, dass die Anordnung eine Verbindungsleitung (Gas-Verbindungsleitung) zum (gasbezogenen) Verbinden des ersten Gehäuses eines ersten Phasenmoduls mit einem ersten Gehäuse eines zweiten Phasenmoduls aufweist. Dadurch kann der gasförmige Stoff einfach und gleichmäßig in den Gehäusen verschiedener Phasenmodule verteilt werden.

Die Anordnung kann dabei so ausgestaltet sein, dass eine elektrische Verbindung zwischen zwei Phasenmodulzweigen innerhalb der Verbindungsleitung (Gas-Verbindungsleitung) zwischen den beiden Phasenmodulzweigen verläuft. Dabei ist vorteilhaft, dass die elektrische Verbindung ebenfalls durch den gasförmigen Stoff in der Gas-Verbindungsleitung elektrisch isoliert werden kann (höhere Durchschlagsfestigkeit gegenüber Luftisolierung).

Die Anordnung kann auch so ausgestaltet sein, dass die Anordnung eine Druckerhöhungseinrichtung zum Erhöhen des Drucks des gasförmigen Stoffes (gegenüber dem außerhalb der Gehäuse herrschenden Außendruck) aufweist. Eine Erhöhung des Drucks des gasförmigen Stoffes (Erhöhung des Gasdrucks) vergrößert grundsätzlich die Durchschlagfestigkeit des gasförmigen Stoffes. Dadurch kann der Abstand zwischen den Submodulen des Stromrichters noch weiter verringert werden bzw. die aus mehreren elektrischen Bauelementen (Bauteilen) aufgebauten Submodule können kompakter aufgebaut werden. Dadurch kann der für den Stromrichter benötigte Platz/Raum deutlich verkleinert werden. Die Druckerhöhungseinrichtung kann insbesondere vorteilhafterweise eingerichtet sein, den Druck in den Gehäusen auf einen Wert zwischen 1,1 Bar und 3 Bar, insbesondere auf einen Wert zwischen 1,1 Bar und 2 Bar, zu erhöhen. Dann ist die Druckerhöhungseinrichtung eingerichtet bzw. ausgestaltet den Druck auf maximal 3 Bar, insbesondere auf maximal 2 Bar, zu erhöhen. Es hat sich herausgestellt, dass bei Drücken von höchstens 3 Bar die Durchschlagfestigkeit des gasförmigen Stoffes in der Regel bereits deutlich vergrößert ist. Der Aufwand zur Realisierung eines diesem (relativ geringen) Druck widerstehenden Gehäuses ist vorteilhafterweise vergleichsweise gering (notwendige mechanische Stabilität des Gehäuses, notwendige Wandstärke des Gehäuses, Stabilität von Dichtungen etc.). Diese moderate Druckerhöhung auf höchstens 3 Bar lässt sich technisch also relativ leicht und kostengünstig umsetzen. Mit anderen Worten lässt sich ein Druck von höchstens 3 Bar technisch relativ einfach beherrschen. Noch leichter lässt sich der Druck beherrschen, wenn er durch die Druckerhöhungseinrichtung auf maximal 2 Bar erhöht wird. Daher ist eine Druckerhöhungseinrichtung vorteilhaft, welche derart eingerichtet bzw. ausgestaltet ist, den Druck auf maximal 2 Bar zu erhöhen. Diese Einrichtung bzw. Ausgestaltung der Druckerhöhungseinrichtung kann beispielsweise durch eine entsprechend programmierte Steuerung oder Regelung realisiert werden.

Die Anordnung kann auch so ausgestaltet sein, dass die Anordnung eine Befeuchtungseinrichtung zum Vergrößern der Menge von in den Gehäusen eingeschlossenem Wasserdampf und/oder eine Entfeuchtungseinrichtung zum Verringern der Menge des in den Gehäusen eingeschlossenen Wasserdampfs aufweist. Der gasförmige Stoff weist also Wasserdampf auf; mit anderen Worten enthält der gasförmige Stoff Wasserdampf. Mittels der Befeuchtungseinrichtung kann die Menge des in den Gehäusen eingeschlossenen Wasserdampfs beeinflusst werden. Insbesondere kann mittels dieser Befeuchtungseinrichtung verhindert werden, dass in den Gehäusen sehr wenig Wasserdampf vorhanden ist (gasförmiger Stoff ist sehr trocken) oder das in den Gehäusen sehr viel Wasserdampf vorhanden ist (gasförmiger Stoff ist sehr feucht). Sehr trockene gasförmige Stoffe und sehr feuchte gasförmige Stoffe weisen nämlich in der Regel eine vergleichsweise geringe elektrische Durchschlagfestigkeit auf. Somit kann mittels der Befeuchtungseinrichtung bzw. der Entfeuchtungseinrichtung sichergestellt werden, dass sich die Menge des in den Gehäusen eingeschlossenen Wasserdampfs in einem Bereich bewegt, in dem der gasförmige Stoff eine vergleichsweise große Durchschlagfestigkeit aufweist. Insbesondere kann die Befeuchtungseinrichtung und/oder die Entfeuchtungseinrichtung eingerichtet sein, die relative Feuchtigkeit in den Gehäusen auf einen Wert zwischen 30 % und 50 % einzustellen. Es hat sich herausgestellt, dass bei einem Wert zwischen 30 % und 50 % relativer Feuchtigkeit in dem gasförmigen Stoff in der Regel eine deutliche Erhöhung der Durchschlagfestigkeit gegenüber trockeneren gasförmigen Stoffen oder feuchteren gasförmigen Stoffen vorliegt. Ein besonders vorteilhafter Wert für die in dem gasförmigen Stoff auftretende relative Feuchtigkeit liegt bei 40 %.

Die Anordnung kann auch so ausgestaltet sein, dass die Anordnung eine Heizeinrichtung zum Erhöhen der Temperatur in den Gehäusen und/oder eine Kühleinrichtung zum Verringern der Temperatur in den Gehäusen aufweist. Mittels der Heizeinrichtung bzw. der Kühleinrichtung lässt sich die Temperatur in den Gehäusen beeinflussen. Bei zu hohen Temperaturen sinkt in der Regel die Durchschlagsfestigkeit des gasförmigen Stoffes, bei zu niedrigen Temperaturen besteht die Gefahr der Bildung eines Kondensats in dem gasförmigen Stoff. Somit kann mittels der Heizeinrichtung bzw. der Kühleinrichtung eine Temperatur in dem gasförmigen Stoff erreicht werden, welche eine vergleichsweise hohe Durchschlagfestigkeit des gasförmigen Stoffes zur Folge hat. Die Heizeinrichtung und/oder die Kühleinrichtung können insbesondere eingerichtet sein, die Temperatur in den Gehäusen auf einen Wert zwischen 5 Grad Celsius und 40 Grad Celsius einzustellen. Vorteilhafterweise ist also die Heizeinrichtung und/oder die Kühleinrichtung derart eingerichtet bzw. ausgestaltet, das eine Temperatur zwischen 5 Grad Celsius und 40 Grad Celsius in den Gehäusen eingestellt wird. Bei einer Temperatur innerhalb dieses Temperaturbereichs ist die Durchschlagfestigkeit des gasförmigen Stoffes in der Regel vergrößert gegenüber höheren Temperaturen. Insbesondere kann die Heizeinrichtung und/oder die Kühleinrichtung derart eingerichtet bzw. ausgestaltet sein, dass eine Temperatur zwischen 5 Grad Celsius und 15 Grad Celsius in den Gehäusen eingestellt wird. Eine Erniedrigung der Temperatur um 30 Grad Celsius verbessert die Durchschlagfestigkeit um ca. 10 %.

Die Anordnung kann so ausgestaltet sein, dass der gasförmige Stoff Luft aufweist. Als gasförmiger Stoff kann also vorteilhafterweise Luft oder ein Gas-Gemisch, welches Luft enthält, verwendet werden. (Mit anderen Worten kann die Anordnung also so ausgestaltet sein, dass der gasförmige Stoff Sauerstoff enthält. Es handelt sich also um einen sauerstoffhaltigen gasförmigen Stoff.) Dies stellt eine sehr kostengünstige Lösung dar. Außerdem ist vorteilhaft, dass Menschen in dem gasförmigen Stoff (ggf. unter Nutzung von Gasmasken) beispielsweise Wartungsarbeiten oder Montagearbeiten ausführen können.

Die Anordnung ist so ausgestaltet, dass der gasförmige Stoff diejenigen Gase aufweist, die in Luft enthalten sind, wobei die Konzentrationen von mindestens zwei dieser Gase des gasförmigen Stoffes sich unterscheiden von den Konzentrationen der jeweiligen Gase in Luft. Diese Variante erlaubt es vorteilhafterweise, durch eine Änderung der Konzentrationen der mindestens zwei Gase die Durchschlagfestigkeit noch weiter zu erhöhen. Dabei kann von üblicher Umgebungsluft ausgegangen werden, der ein Gas (welches in Luft sowieso enthalten ist) zusätzlich beigefügt wird. Dadurch lässt sich die Durchschlagfestigkeit des gasförmigen Stoffes nochmals erhöhen.

Die Anordnung ist so ausgestaltet, dass der gasförmige Stoff Stickstoff und Kohlendioxid aufweist, wobei die Konzentration des Stickstoffs und/oder die Konzentration des Kohlendioxids erhöht sind gegenüber der jeweiligen Konzentration des Stickstoffs und/oder des Kohlendioxids in Luft. Vorteilhafterweise wird durch die Erhöhung der Konzentration des Stickstoffs bzw. und/oder die Erhöhung der Konzentration des Kohlendioxids die Durchschlagfestigkeit des gasförmigen Stoffes vergrößert. Die Konzentration von Stickstoff in Luft beträgt ca. 78 %, die Konzentration von Kohlendioxid in Luft beträgt ca. 0,04 %. Mit anderen Worten ist also bei der Anordnung die Konzentration des Stickstoffs höher als 78 % und/oder die Konzentration des Kohlendioxids ist höher als 0,04 %. (Kohlendioxid CO₂ wird auch als Kohlenstoffdioxid bezeichnet.) Die Anordnung kann insbesondere so ausgestaltet sein, dass der gasförmige Stoff das Gas Kohlendioxid in einer Konzentration größer als 2 %, insbesondere in einer Konzentration größer als 10 %, aufweist. Bei diesen Konzentrationen des Kohlendioxids ist die Durchschlagfestigkeit des gasförmigen Stoffes gegenüber der Durchschlagfestigkeit von Luft bereits deutlich vergrößert.

Zu beachten ist, dass beim Einatmen von Kohlendioxid in einer Konzentration größer als ca. 5 % beim Menschen Kopfschmerzen, Schwindel oder Bewusstlosigkeit auftreten können. Daher sollten geeignete Vorkehrungen getroffen werden, damit bei einer Wartung oder Reparatur des Stromrichters ein Einatmen von großen Mengen Kohlendioxid verhindert wird.

Die Anordnung kann so ausgestaltet sein, dass die Druckerhöhungseinrichtung, die Befeuchtungseinrichtung, die Entfeuchtungseinrichtung, die Heizeinrichtung und/oder die Kühleinrichtung mittels mindestens einer Verbindungsleitung mit den Gehäusen verbunden ist.

Insbesondere kann der Stromrichter ein Hochspannungs-Stromrichter sein (der insbesondere für Spannungen größer als 20 kV ausgelegt ist). Bei derartigen Hochspannungs-Stromrichtern würde aufgrund der hohen Spannung bei herkömmlicher Luftisolation ein besonders großer Platz/Raum zur Isolierung benötigt, der sich durch die vorstehend beschriebenen Anordnungen deutlich reduzieren lässt.

Offenbart wird weiterhin ein Verfahren zum Beeinflussen von Betriebsbedingungen eines Stromrichters, der mindestens ein Phasenmodul, einen Wechselspannungsanschluss, einen ersten Gleichspannungsanschluss und einen zweiten Gleichspannungsanschluss aufweist, wobei zwischen dem Wechselspannungsanschluss und dem ersten Gleichspannungsanschluss ein erster Phasenmodulzweig ausgebildet ist, zwischen dem Wechselspannungsanschluss und dem zweiten Gleichspannungsanschluss ein zweiter Phasenmodulzweig ausgebildet ist, jeder Phasenmodulzweig mindestens zwei Submodule aufweist, die Submodule des ersten Phasenmodulzweigs von einem ersten (gemeinsamen) Gehäuse umgeben sind, die Submodule des zweiten Phasenmodulzweigs von einem zweiten (gemeinsamen) Gehäuse umgeben sind und das erste Gehäuse und das zweite Gehäuse mit einem gasförmigen Stoff gefüllt sind, wobei bei dem Verfahren der Druck des gasförmigen Stoffs (gegenüber dem außerhalb der Gehäuse herrschenden Außendruck) erhöht wird. Vorteilhafterweise kann der Druck des gasförmigen Stoffs auf einen Wert innerhalb eines vorgegebenen Druckbereichs eingestellt (insbesondere erhöht) werden. Insbesondere kann der Druck des gasförmigen Stoffs auf einen Wert zwischen 1,1 Bar und 3 Bar, insbesondere auf einen Wert zwischen 1,1 Bar und 2 Bar, eingestellt (insbesondere erhöht) werden.

Das Verfahren kann auch so ausgestaltet sein, dass die Menge von in dem gasförmigen Stoff enthaltenen Wasserdampf beeinflusst (insbesondere vergrößert oder verkleinert) wird. Der gasförmige Stoff weist hierbei also Wasserdampf auf. Vorteilhafterweise kann dabei die Menge des in dem gasförmigen Stoff enthaltenen Wasserdampfes derart beeinflusst werden, dass der gasförmige Stoff eine relative Feuchtigkeit zwischen 30 % und 50 % aufweist.

Das Verfahren kann so ausgestaltet sein, dass die Temperatur des gasförmigen Stoffes auf einen Wert innerhalb eines vorgegebenen Temperaturbereichs eingestellt wird. Vorteilhafterweise kann dabei die Temperatur des gasförmigen Stoffes auf einen Wert zwischen 5 Grad Celsius und 40 Grad Celsius eingestellt werden.

Das Verfahren läuft so ab, dass der gasförmige Stoff Stickstoff und Kohlendioxid aufweist, und die Konzentration des Stickstoffs und/oder die Konzentration des Kohlendioxids erhöht wird gegenüber der jeweiligen Konzentration des Stickstoffs und/oder des Kohlendioxids in Luft. Die Konzentration von Stickstoff in Luft beträgt ca. 78 %, die Konzentration von Kohlendioxid in Luft beträgt ca. 0,04 %. Mit anderen Worten wird also die Konzentration des Stickstoffs auf Werte größer als 78 % erhöht und/oder die Konzentration des Kohlendioxids wird auf Werte größer als 0,04 % erhöht.

Die beschriebenen Varianten des Verfahrens weisen gleichartige Vorteile auf, wie sie oben im Zusammenhang mit den Varianten der Anordnung beschrieben sind.

Im Folgenden wird die Erfindung anhand von Ausführungsbeispielen näher erläutert. Gleiche Bezugszeichen verweisen dabei auf gleiche oder gleichwirkende Elemente. Dabei ist in
- Figur 1: ein erstes Ausführungsbeispiel einer Anordnung mit einem Stromrichter, in
- Figur 2: ein zweites Ausführungsbeispiel einer Anordnung mit einem Stromrichter, in
- Figur 3: ein weiteres Ausführungsbeispiel einer Anordnung mit einem Stromrichter, in
- Figur 4: ein weiteres Ausführungsbeispiel einer Anordnung mit einem Stromrichter, in
- Figur 5: ein Ausführungsbeispiel eines als Halbbrücke ausgestalteten Submoduls, in
- Figur 6: ein Ausführungsbeispiel eines als Vollbrücke ausgestalteten Submoduls und in
- Figur 7: ein Ausführungsbeispiel eines Verfahrens zum Beeinflussen von Betriebsbedingungen eines Stromrichters
dargestellt.

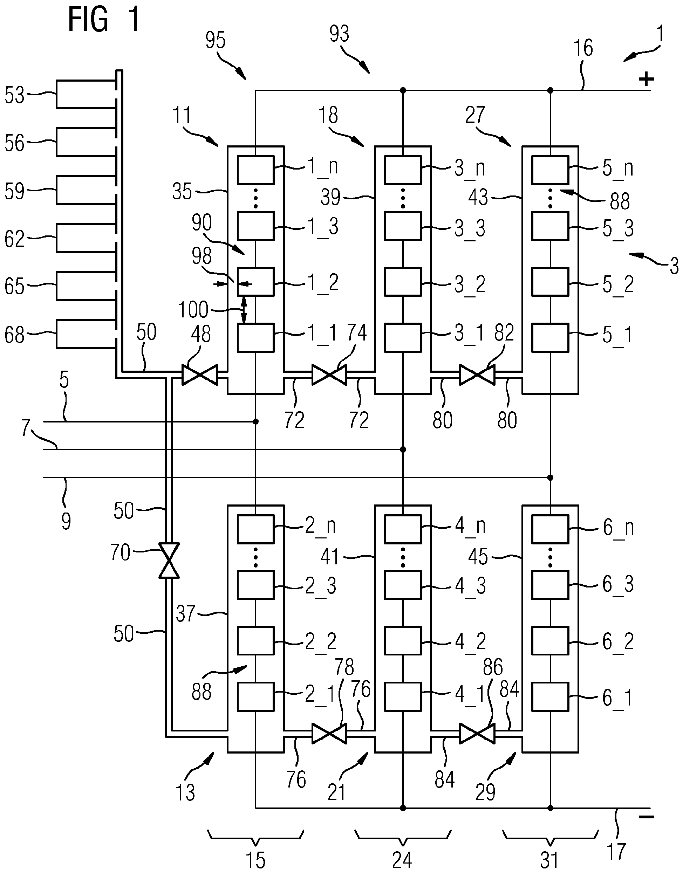

In Figur 1 ist eine Anordnung 1 mit einem Stromrichter 3 dargestellt. Dieser Stromrichter 3 weist einen ersten Wechselspannungsanschluss 5, einen zweiten Wechselspannungsanschluss 7 und einen dritten Wechselspannungsanschluss 9 auf. Der erste Wechselspannungsanschluss 5 ist elektrisch mit einem ersten Phasenmodulzweig 11 und einem zweiten Phasenmodulzweig 13 verbunden. Der erste Phasenmodulzweig 11 und der zweite Phasenmodulzweig 13 bilden ein erstes Phasenmodul 15 des Stromrichters 3. Das dem ersten Wechselspannungsanschluss 5 abgewandte Ende des ersten Phasenmodulzweigs 11 ist mit einem ersten Gleichspannungsanschluss 16 elektrisch verbunden; das dem ersten Wechselspannungsanschluss 5 abgewandte Ende des zweiten Phasenmodulzweigs 13 ist mit einem zweiten Gleichspannungsanschluss 17 elektrisch verbunden. Der erste Gleichspannungsanschluss 16 ist ein positiver Gleichspannungsanschluss; der zweite Gleichspannungsanschluss 17 ist ein negativer Gleichspannungsanschluss.

Der zweite Wechselspannungsanschluss 7 ist mit einem Ende des dritten Phasenmodulzweigs 18 elektrisch verbunden und mit einem Ende eines vierten Phasenmodulzweigs 21 elektrisch verbunden. Der dritte Phasenmodulzweig 18 und der vierte Phasenmodulzweig 21 bilden ein zweitens Phasenmodul 24. Der dritte Wechselspannungsanschluss 9 ist mit einem Ende eines fünften Phasenmodulzweigs 27 und mit einem Ende eines sechsten Phasenmodulzweigs 29 elektrisch verbunden. Der fünfte Phasenmodulzweig 27 und der sechste Phasenmodulzweig 29 bilden ein drittes Phasenmodul 31.

Das dem zweiten Wechselspannungsanschluss 7 abgewandte Ende des dritten Phasenmodulzweigs 18 und das dem dritten Wechselspannungsanschluss 9 abgewandte Ende des fünften Phasenmodulzweigs 27 ist mit dem ersten Gleichspannungsanschluss 16 elektrisch verbunden. Das dem zweiten Wechselspannungsanschluss 7 abgewandte Ende des vierten Phasenmodulzweigs 21 und das dem dritten Wechselspannungsanschluss 9 abgewandte Ende des sechsten Phasenmodulzweigs 29 ist mit dem zweiten Gleichspannungsanschluss 17 elektrisch verbunden. Im Ausführungsbeispiel ist der Stromrichter ein modularer Multilevel-Umrichter(modular multilevel converter, MMC). Jeder Phasenmodulzweig weist eine Mehrzahl von Submodulen (1_1, 1_2, 1_3, ... 1_n) auf, welche elektrisch in Reihe geschaltet sind. Im Ausführungsbeispiel der Figur 1 weist jeder Phasenmodulzweig n Submodule auf. Die Anzahl der elektrisch in Reihe geschalteten Submodule kann sehr verschieden sein, mindestens sind zwei Submodule in Reihe geschaltet, es können aber auch beispielsweise 50 oder 100 Submodule elektrisch in Reihe geschaltet sein. Im Ausführungsbeispiel ist n = 32: der erste Phasenmodulzweig weist als 32 Submodule 1_1, 1_2, 1_3, ... 1_32 auf.

Die Submodule 1_1 ... 1_32 des ersten Phasenmodulzweigs 11 sind von einem ersten Gehäuse 35 umgeben. Dieses erste Gehäuse 35 ist zur Aufnahme eines gasförmigen Stoffs geeignet, mit anderen Worten ist das erste Gehäuse 35 für einen bestimmten Druck gasdicht ausgeführt. In gleicher Weise sind die Submodule 2_1, 2_2 ... 2_n des zweiten Phasenmodulzweigs 13 von einem zweiten Gehäuse 37 umgeben, welches zur Aufnahme des gasförmigen Stoffes geeignet ist. Gleichartig sind die Submodule 3_1 ... 3_n des dritten Phasenmodulzweigs 18 von einem dritten Gehäuse 39 umgeben, und die Submodule 4_1 ... 4_n des vierten Phasenmodulzweigs 21 sind von einem vierten Gehäuse 41 umgeben. Die Submodule 5_1 ... 5_n des fünften Phasenmodulzweigs 27 sind von einem fünften Gehäuse 43 umgeben und die Submodule 6_1 ... 6_n des sechsten Phasenmodulzweigs 29 sind von einem sechsten Gehäuse 45 umgeben.

Wenn im Folgenden allgemein von ,den Gehäusen' die Rede ist, dann sind damit das erste Gehäuse und das zweite Gehäuse des ersten Phasenmodulzweigs und das dritte Gehäuse und das vierte Gehäuse des zweiten Phasenmodulzweigs (falls vorhanden) und das fünfte Gehäuse und das sechste Gehäuse des dritten Phasenmodulzweigs (falls vorhanden) gemeint. Die Gehäuse dienen also zur Aufnahme eines gasförmigen Stoffes. Mit anderen Worten sind die Gehäuse mit einem gasförmigen Stoff gefüllt. In jedem Gehäuse befinden sich also die Submodule eines Phasenmodulzweigs und der gasförmige Stoff.

Die Gehäuse können elektrisch auf einem definierten Potential liegen, insbesondere auf Erdpotential.

Das erste Gehäuse 35 ist über eine erste Gas-Absperreinrichtung 48 und eine Verbindungsleitung 50 (Gasleitung 50) gasbezogen mit einer Druckerhöhungseinrichtung 53, einer Befeuchtungseinrichtung 56, einer Entfeuchtungseinrichtung 59, einer Heizeinrichtung 62, einer Kühleinrichtung 65 und einer Gaszuführeinrichtung 68 verbunden. Die Einrichtungen 53, 56, 59, 62, 65 und 68 sind über die Gasleitung 50 und eine zweite Gas-Absperreinrichtung 70 auch mit dem zweiten Gehäuse 37 verbunden. Die Druckerhöhungseinrichtung 53, die Befeuchtungseinrichtung 56, die Entfeuchtungseinrichtung 59, die Heizeinrichtung 62, die Kühleinrichtung 65 und die Gaszuführeinrichtung 68 bilden eine Aufbereitungseinrichtung für den gasförmigen Stoff, die auch als Gasaufbereitungseinrichtung bezeichnet wird.

Bei anderen Ausführungsbeispielen können auch eine oder mehrere der genannten Einrichtungen weggelassen werden, beispielsweise kann die Heizeinrichtung 62 weggelassen werden, wenn sichergestellt ist, dass bei Betrieb des Stromrichters stets eine gewünschte Mindesttemperatur vorliegt.

Das erste Gehäuse 35 ist über eine erste Verbindungsleitung 72 (Gas-Verbindungsleitung 72) und über eine dritte Absperreinrichtung 74 (Gas-Absperreinrichtung 74) mit dem dritten Gehäuse 39 verbunden. In gleicher Weise ist das zweite Gehäuse 37 über eine zweite Gas-Verbindungsleitung 76 und eine vierte Gas-Absperreinrichtung 78 mit dem vierten Gehäuse 41 verbunden. Das dritte Gehäuse 39 ist über eine dritte Gas-Verbindungsleitung 80 und eine fünfte Gas-Absperreinrichtung 82 mit dem fünften Gehäuse 43 verbunden. Das vierte Gehäuse 41 ist über eine vierte Gas-Verbindungsleitung 84 und eine sechste Gas-Absperreinrichtung 86 mit dem sechsten Gehäuse 45 verbunden.

Mittels der ersten Gas-Verbindungsleitung 72 ist also das erste Gehäuse 35 des ersten Phasenmoduls 15 mit dem dritten Gehäuse 39 des zweiten Phasenmoduls 24 (gasbezogen) verbunden. Bei Bedarf kann diese gasbezogene Verbindung mittels der dritten Gas-Absperreinrichtung 74 getrennt werden, die dritte Gas-Absperreinrichtung 74 dient also zum gasbezogenen Trennen des ersten Gehäuses 35 von dem dritten Gehäuse 39.

In dem ersten Gehäuse 35, in dem zweiten Gehäuse 37, in dem dritten Gehäuse 39, in dem vierten Gehäuse 41, in dem fünften Gehäuse 43 und in dem sechsten Gehäuse 45 befindet sich jeweils ein gasförmiger Stoff 88, vorzugsweise handelt es sich dabei um denselben gasförmigen Stoff. Mit anderen Worten gesagt, dient beispielsweise das erste Gehäuse 35 zur Aufnahme des gasförmigen Stoffs 88. Der gasförmige Stoff 88 befindet sich also in einem Innenraum 90 des ersten Gehäuses 35. Mit anderen Worten ist das erste Gehäuse 35 mit dem gasförmigen Stoff 88 gefüllt. In dem ersten Gehäuse 35 befinden sich also mindestens die Submodule 1_1 bis 1_n sowie der gasförmige Stoff 88.

Die Druckerhöhungseinrichtung 53 dient zum Erhöhen des Drucks des in den Gehäusen eingeschlossenen gasförmigen Stoffes 88. Die Druckerhöhungseinrichtung 53 erhöht also beispielsweise den Druck des gasförmigen Stoffs 88 im Innenraum 90 des ersten Gehäuses 35 gegenüber dem außerhalb des Gehäuses 35 auftretenden Außendruck. Somit befindet sich innerhalb des ersten Gehäuses 35 (d. h. im Innenraum 90) ein Überdruck. Die Druckerhöhungseinrichtung 53 ist so ausgebildet, dass diese den Druck innerhalb des ersten Gehäuses 35 auf einen vorgewählten Wert zwischen 1,1 bar und 3 bar einstellt (1 bar = 100 kPa). Vorteilhafterweise kann die Druckerhöhungseinrichtung auch so ausgebildet sein, dass diese den Druck innerhalb des ersten Gehäuses 35 auf einen vorgewählten Wert zwischen 1,1 bar und 2 bar einstellt. Dieser erhöhte Druck wird während des Betriebs des Stromrichters 3 mittels der Druckerhöhungseinrichtung 53 auf dem gewählten Wert konstant gehalten. Dazu kann die Druckerhöhungseinrichtung 53 eine als solche bekannte Regelungseinrichtung aufweisen. Die Druckerhöhungseinrichtung 53 kann beispielsweise eine Pumpe oder ein Kompressor sein.

Die Befeuchtungseinrichtung 56 dient zum Vergrößern der Menge von in den Innenräumen der Gehäuse 35, 37, 39, 41, 43 und 45 enthaltenem Wasserdampf; die Entfeuchtungseinrichtung 59 dient zum Verringern der Menge von in den Innenräumen der Gehäuse 35, 37, 39, 41, 43 und 45 enthaltenem Wasserdampf. Die Befeuchtungseinrichtung 56 kann beispielsweise als ein Verdampfer (Wasser-Verdampfer) ausgebildet sein, während die Entfeuchtungseinrichtung 59 als eine Wasser-Kondensationseinrichtung ausgebildet sein kann. Mittels der Befeuchtungseinrichtung 56 und/oder der Entfeuchtungseinrichtung 59 wird die relative Feuchtigkeit in den Innenräumen der Gehäuse 35, 37, 39, 41, 43 und 45 auf einen vorgewählten Wert zwischen 30 % und 50 % relativer Feuchtigkeit eingestellt bzw. geregelt. Beispielsweise stellt die Befeuchtungseinrichtung 56 und/oder die Entfeuchtungseinrichtung 59 die in dem gasförmigen Stoff 88 auftretende relative Feuchtigkeit auf einen Wert von 40 % ein.

Mittels der Heizeinrichtung 62 kann die Temperatur des gasförmigen Stoffs 88 in den Gehäusen 35, 37, 39, 41, 43 und 45 erhöht werden; mittels der Kühleinrichtung 65 kann die Temperatur des gasförmigen Stoffes 88 in den Gehäusen 35, 37, 39, 41, 43 und 45 verringert werden. Die Heizeinrichtung 62 und/oder die Kühleinrichtung 65 sind so eingerichtet bzw. ausgestaltet, dass diese die Temperatur des gasförmigen Stoffes 88 in den Innenräumen der Gehäuse 35, 37, 39, 41, 43 und 45 auf einen vorgewählten Wert zwischen 5°C und 40°C einstellen bzw. regeln. Die Befeuchtungseinrichtung 56, die Entfeuchtungseinrichtung 59, die Heizeinrichtung 62 und/oder die Kühleinrichtung 65 können insbesondere durch eine als solche bekannte Klimaanlage realisiert sein.

Mittels der Gaszufuhreinrichtung 68 wird der gasförmige Stoff 88 in den Innenraum der Gehäuse 35, 37, 39, 41, 43 und 45 eingebracht. Bei dem gasförmigen Stoff 88 kann es sich beispielsweise um Luft handeln. In diesem Fall ist die Gaszuführeinrichtung als eine Luftzuführung ausgestaltet, welche Luft 93 (Umgebungsluft) aus dem Außenraum 95 der Gehäuse in den Innenraum 90 der Gehäuse 35, 37, 39, 41, 43 und 45 befördert.

Der gasförmige Stoff 88 innerhalb der Gehäuse 35, 37, 39, 41, 43 und 45 kann aber auch so ausgebildet sein, dass der gasförmige Stoff 88 diejenigen Gase aufweist, welche auch in herkömmlicher Luft 93 enthalten sind. Allerdings unterscheiden sich die Konzentrationen von mindestens zwei dieser Gase des gasförmigen Stoffes 88 von den Konzentrationen der jeweiligen Gase in herkömmlicher Luft 93. Dies wird dadurch erreicht, dass die Gaszuführungseinrichtung 68 eine oder mehrere Gasspeicher (z. B. Druckgasflaschen) aufweist. Die Gaszuführungseinrichtung 68 gibt ein in diesen Gasspeichern jeweils gespeichertes Gas in den Innenraum 90 der Gehäuse 35, 37, 39, 41, 43 und 45 ab.

Beispielsweise kann die Gaszuführungseinrichtung 68 einen Gasspeicher mit Stickstoff aufweisen. Die Gaszuführeinrichtung 68 gibt dann kontrolliert Stickstoff aus diesem Gasspeicher in den Innenraum 90 der Gehäuse 35, 37, 39, 41, 43 und 45 ab, dadurch wird die Konzentration des Stickstoffs gegenüber der Konzentration des Stickstoffs in herkömmlicher Luft 93 erhöht. Natürlich können in der Gaszuführungseinrichtung 68 auch Gasspeicher mit anderen Gasen enthalten sein, beispielsweise Gasspeicher mit Kohlendioxid oder Gasspeicher mit Argon.

Derartige Gase (die auch in herkömmlicher Umgebungsluft 93 enthalten sind) haben den Vorteil, dass sie in der Regel nicht oder nur wenig umweltschädlich und/oder ungiftig sind, so dass sie bei einer Wartung einfach in den Außenraum 95 (und dann in die Atmosphäre) abgelassen werden können. Dies ist beispielsweise ein erheblicher Vorteil gegenüber dem Gas Schwefelhexafluorid SF₆, welches zwar sehr gute Isolationseigenschaften aufweist, jedoch auch in hohem Maße klimaschädlich ist.

Mittels der Druckerhöhungseinrichtung 53, der Befeuchtungseinrichtung 56, der Entfeuchtungseinrichtung 59, der Heizeinrichtung 62, der Kühleinrichtung 65 und/oder der Gaszuführungseinrichtung 68 werden die im Innenraum 90 der Gehäuse 35, 37, 39, 41, 43 und 45 vorliegenden Betriebsbedingungen/Umgebungsbedingungen des Stromrichters 3 beeinflusst. Im Ausführungsbeispiel der Figur 1 werden insbesondere die Betriebsbedingungen/Umgebungsbedingungen der in den Gehäusen 35, 37, 39, 41, 43 und 45 angeordneten Submodule 1_1 ... 6_n sowie der elektrischen Verbindungsleitungen zwischen diesen Submodulen beeinflusst. Insbesondere werden der diese Submodule umgebende Druck, die die Submodule umgebende Feuchtigkeit und die die Submodule umgebende Temperatur beeinflusst und auf vorteilhafte Werte gebracht.

Mit anderen Worten wird im Innenraum 90 der Gehäuse 35, 37, 39, 41, 43 und 45 eine kontrollierte Atmosphäre geschaffen, in der die Submodule betrieben werden. Mittels der genannten Größen (Zusammensetzung des gasförmigen Stoffes 88, Druck, Feuchtigkeit und/oder Temperatur) wird erreicht, dass die Durchschlagfestigkeit des gasförmigen Stoffes 88 erhöht wird. Dadurch kann beispielsweise ein erster Abstand 98 zwischen den Submodulen 1_1, 1 2, ... 6 n und den jeweiligen Gehäusen 35, 37, 39, 41, 43 oder 45 relativ klein sein. Ebenso kann auch ein zweiter Abstand 100 zwischen beispielsweise dem Submodul 1_1 und dem Submodul 1_2 in dem ersten Gehäuse 35 relativ klein gewählt werden. Beispielsweise ist es denkbar, dass die erforderlichen Abstände um 50 % reduziert werden gegenüber einer herkömmlichen Luftisolierung.

Die vorstehend am Beispiel des ersten Gehäuses 35 beschriebenen Wirkungsweisen treffen auch auf die anderen Gehäuse (also auf das zweite Gehäuse 37, das dritte Gehäuse 39, das vierte Gehäuse 41, das fünfte Gehäuse 43 sowie das sechste Gehäuse 45) zu. Beispielsweise können also mittels der Druckerhöhungseinrichtung 53 auch die Drücke in diesen genannten Gehäusen erhöht werden und mit der Befeuchtungseinrichtung 56 kann die Menge des Wasserdampfs in den Gehäusen 37, 39, 41, 43 und 45 auch beeinflusst werden. Wenn nämlich alle sechs Gas-Absperreinrichtungen 48, 70, 74, 78, 82 und 86 geöffnet sind, dann sind das erste Gehäuse 35, das zweite Gehäuse 37, das dritte Gehäuse 39, das vierte Gehäuse 41, das fünfte Gehäuse 43 und das sechste Gehäuse 45 gasbezogen miteinander verbunden, so dass mittels der Einrichtungen 53, 56, 59, 62, 65 und 68 der gasförmige Stoff in alles sechs Gehäusen beeinflusst werden kann.

Im Ausführungsbeispiel weist der Stromrichter 3 drei Phasenmodule 15, 24 und 31 für die drei Phasen einer 3-Phasen-Wechselspannung auf. In anderen Ausführungsbeispielen kann der Stromrichter jedoch auch weniger oder mehr Phasenmodule aufweisen, beispielsweise 1 Phasenmodul, 2 Phasenmodule oder 6 Phasenmodule.

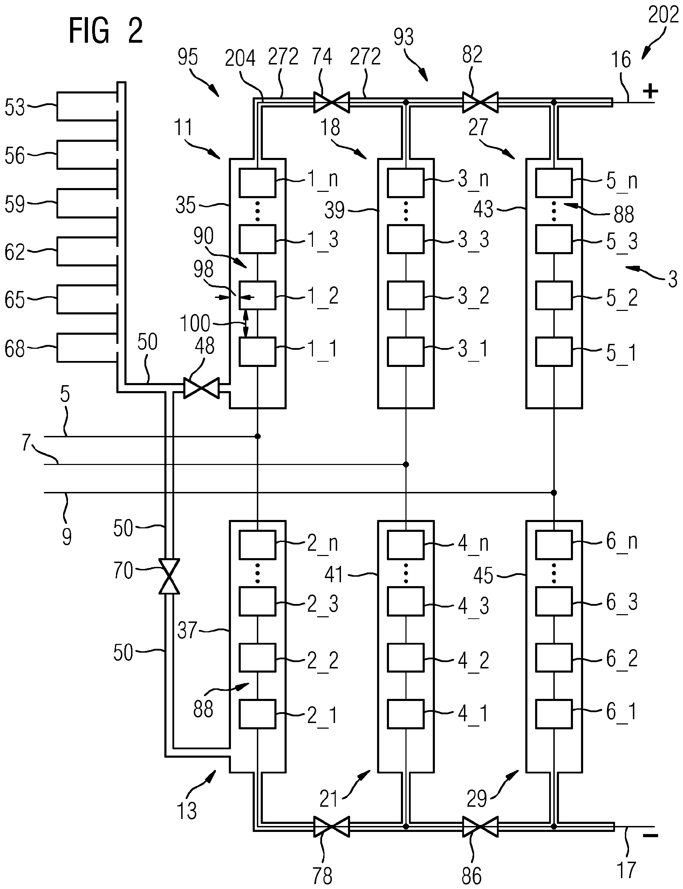

In Figur 2 ist ein weiteres Ausführungsbeispiel einer Anordnung 202 mit dem Stromrichter 3 dargestellt. Dieses Ausführungsbeispiel unterscheidet sich von dem Ausführungsbeispiel der Figur 1 lediglich dadurch, dass die gasbezogenen Verbindungen zwischen den einzelnen Gehäusen anders realisiert sind. Die Gas-Verbindungsleitungen zwischen den einzelnen Gehäusen sind so ausgebildet, dass die elektrischen Verbindungen zwischen den einzelnen Phasenmodulzweigen innerhalb der jeweiligen Gas-Verbindungsleitung zwischen den jeweiligen Phasenmodulzweigen verlaufen. So verläuft beispielsweise die elektrische Verbindung 204 zwischen dem ersten Phasenmodulzweig 11 und dem dritten Phasenmodulzweig 18 innerhalb einer Gas-Verbindungsleitung 272. Das hat den Vorteil, dass auch bei der elektrischen Verbindung 204 mittels des die elektrische Verbindung 204 umgebenden gasförmigen Stoffes 88 die Durchschlagsfestigkeit vergrößert ist gegenüber einer herkömmlichen Luftisolierung. Dies trifft auch auf die anderen elektrischen Verbindungen zwischen dem dritten Gehäuse 39 und dem fünften Gehäuse 43, zwischen dem zweiten Gehäuse 37 und dem vierten Gehäuse 41 und zwischen dem vierten Gehäuse 41 und dem sechsten Gehäuse 45 zu.

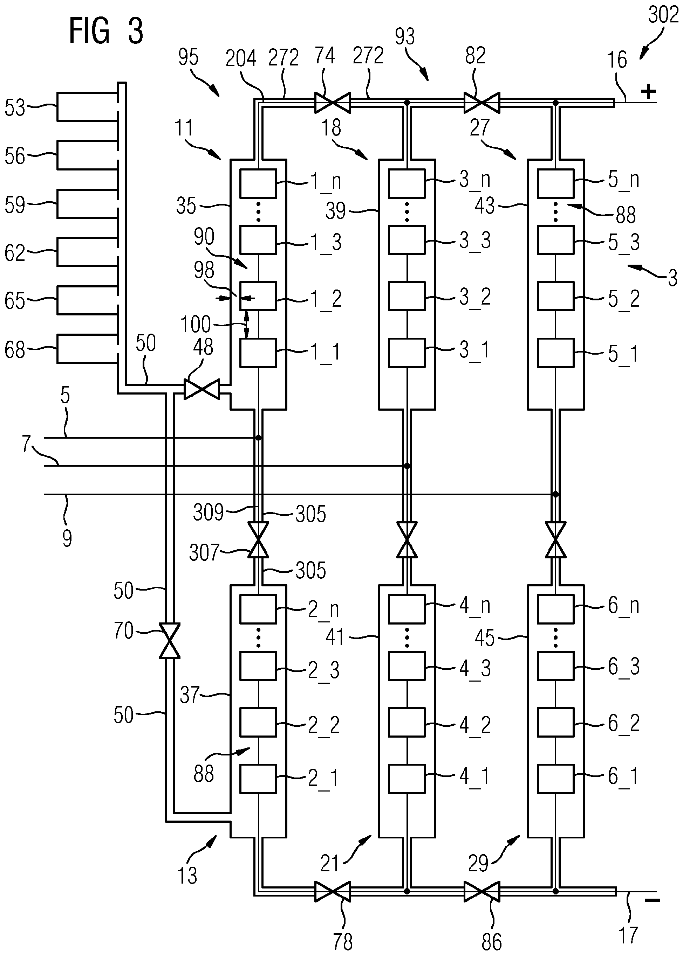

In Figur 3 ist ein weiteres Ausführungsbeispiel einer Anordnung 302 mit dem Stromrichter 3 dargestellt. Dieses Ausführungsbeispiel unterscheidet sich von dem Ausführungsbeispiel der Figur 2 dadurch, dass die Gas-Verbindungsleitung zwischen den beiden Gehäusen eines Phasenmoduls anders ausgestaltet ist. Beispielsweise sind beim ersten Phasenmodul 15 das erste Gehäuse 35 und das zweite Gehäuse 37 unmittelbar durch eine Gas-Verbindungsleitung 305 (gasbezogen) verbunden. Bei Bedarf kann diese gasbezogene Verbindung durch eine Gas-Absperreinrichtung 307 getrennt werden. Dabei verläuft die elektrische Verbindung 309 zwischen dem ersten Phasenmodulzweig 11 und dem zweiten Phasenmodulzweig 13 innerhalb der Gas-Verbindungsleitung 305. Ein Teil des ersten Wechselspannungsanschlusses 5 verläuft ebenfalls innerhalb der Gas-Verbindungsleitung 305. Dies hat den Vorteil, dass die elektrische Verbindungsleitung 309 sowie ein Teil des ersten Wechselspannungsanschlusses 5 in dem gasförmigen Stoff 88 verlaufen. Dadurch ist auch für die elektrische Verbindungsleitung 309 und den Teil des ersten Wechselspannungsanschlusses 5 die elektrische Durchschlagfestigkeit erhöht gegenüber einer herkömmlichen Luftisolierung.

Dies trifft auch auf die elektrische Verbindung und die Gas-Verbindungsleitung zwischen dem dritten Phasenmodulzweig 18 und dem vierten Phasenmodulzweig 21 zu und auf die elektrische Verbindung und die zugehörige Gas-Verbindungsleitung zwischen dem fünften Phasenmodulzweig 27 und dem sechsten Phasenmodulzweig 29 zu.

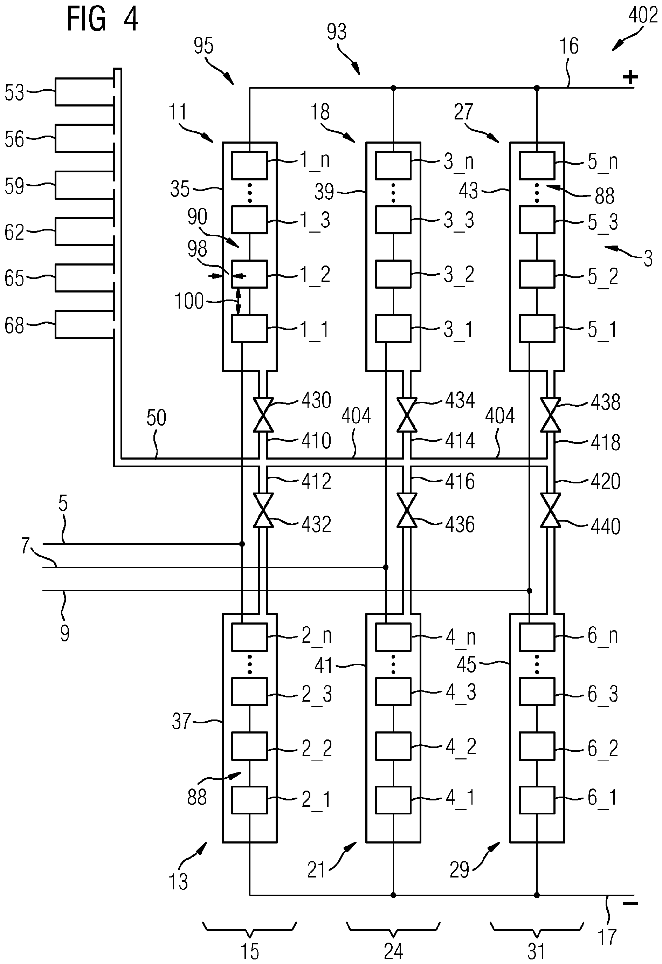

In Figur 4 ist ein weiteres Ausführungsbeispiel einer Anordnung 402 mit dem Stromrichter 3 dargestellt. Bei diesem Ausführungsbeispiel besteht jeweils eine direkte Gas-Verbindung zwischen der Gasaufbereitungseinrichtung und den Gehäusen 35, 37, 39, 41, 43 und 45, insbesondere besteht jeweils eine direkte Gas-Verbindung zwischen der Gaszuführeinrichtung 68 und den Gehäusen 35, 37, 39, 41, 43 und 45. Die Gasleitung 50 verbindet die Gaszuführeinrichtung 68 mit einer zentralen Gas-Verbindungsleitung 404. Die zentrale Gas-Verbindungsleitung 404 ist mittels Gas-Verbindungsleitungen 410, 412, 414, 416, 418 und 420 mit den einzelnen Gehäusen verbunden. Über die zentrale Gas-Verbindungsleitung 404 sind die Gehäuse 35, 37, 39, 41, 43 und 45 auch untereinander verbunden. Mittels Absperreinrichtungen 430, 432, 434, 436, 438 und 440 kann die Gasverbindung zwischen den Gehäusen 35, 37, 39, 41, 43 und 45 und der zentralen Gas-Verbindungsleitung 404 jeweils bedarfsweise unterbrochen oder freigegeben werden. Dieses Ausführungsbeispiel ermöglicht es beispielsweise, die einzelnen Gehäuse unabhängig voneinander mit Gas zu befüllen oder zu entleeren.

Obwohl nicht in Figur 4 dargestellt, können auch bei diesem Ausführungsbeispiel die elektrischen Verbindungsleitungen (insbesondere die Wechselspannungsanschlüsse 5, 7 und 9) ganz oder teilweise innerhalb der zentralen Gas-Verbindungsleitung 404 und/oder innerhalb der Gas-Verbindungsleitungen 410, 412, 414, 416, 418 und 420 verlaufen. Dadurch ist für die elektrischen Verbindungsleitungen die elektrische Durchschlagfestigkeit erhöht im Vergleich zu einer herkömmlichen Luftisolierung.

Generell ist zu den Ausführungsbeispielen anzumerken, dass die Gas-Verbindungsleitungen nur schematisch in den Figuren 1 bis 4 dargestellt sind. Beispielsweise sind optional (um ein schnelles und vollständiges Befüllen und Entleeren der Gehäuse zu ermöglichen) die Gehäuse jeweils zusätzlich mittels einer Gas-Rückleitung mit der Gasaufbereitungseinrichtung verbunden. Die Gehäuse sind dann in einem Gas-Kreislauf angeordnet. Außerdem sind optional zusätzlich Vorrichtungen zum Spülen der Gehäuse mit Luft (z.B. bevor Menschen innerhalb der Gehäuse Arbeiten vornehmen) und zum Entfernen der Luft aus den Gehäusen vorgesehen. Solche Vorrichtungen und solche Gas-Rückleitungen sind jedoch aus Gründen der Übersichtlichkeit nicht in den Figuren 1 bis 4 dargestellt.

Bei den Verbindungsleitungen 50, 72, 76, 80, 84, 404, 410, 412, 414, 416, 418 und 420 handelt es sich jeweils um eine Gas-Verbindungsleitung (Gasleitung). Dies trifft auf alle Verbindungsleitungen zu, die den gasförmigen Stoff 88 in dem Stromrichter 3 verteilen.

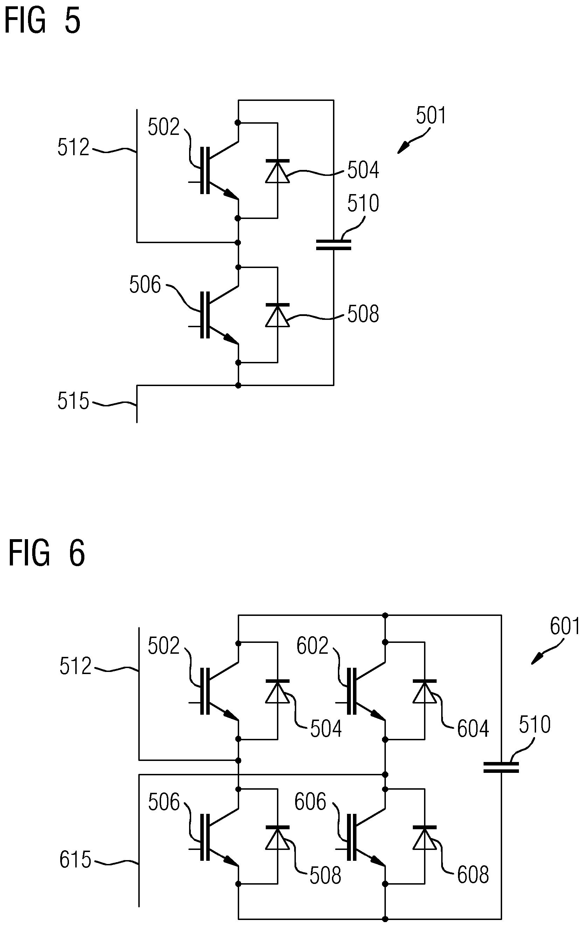

In Figur 5 ist beispielhaft der prinzipielle Aufbau eines Submoduls 501 dargestellt. Dabei kann es sich beispielsweise um das Submodul 1_1 des ersten Phasenmodulzweigs 11 (oder auch um eines der anderen in Figur 1 dargestellten Submodule) handeln. Das Submodul ist als ein Halbbrückenmodul 501 ausgestaltet. Das Submodul 501 weist ein erstes abschaltbares Halbleiterventil 502 mit einer ersten antiparallel geschalteten Diode 504 auf. Weiterhin weist das Submodul 501 ein zweites abschaltbares Halbleiterventil 506 mit einer zweiten antiparallel geschalteten Diode 508 sowie einen Energiespeicher in Form eines Kondensators 510 auf. Das erste abschaltbare Halbleiterventil 502 ist elektrisch in Reihe geschaltet mit dem zweiten abschaltbaren Halbleiterventil 506. Am Verbindungspunkt zwischen den beiden Halbleiterventilen ist ein erster Submodulanschluss 512 angeordnet. An dem dem Verbindungspunkt gegenüberliegenden Anschluss des zweiten Halbleiterventils 506 ist ein zweiter Submodulanschluss 515 angeordnet. Der zweite Submodulanschluss 515 ist weiterhin mit einem ersten Anschluss des Energiespeichers 510 verbunden, ein zweiter Anschluss des Energiespeichers 510 ist elektrisch verbunden mit dem Anschluss des ersten Halbleiterventils 502, der dem Verbindungspunkt gegenüberliegt.

Der Energiespeicher 510 ist also elektrisch parallel geschaltet zu der Reihenschaltung aus dem ersten Halbleiterventil 502 und dem zweiten Halbleiterventil 506. Durch entsprechende Ansteuerung des ersten Halbleiterventils 502 und des zweiten Halbleiterventils 506 (diese Ansteuerung ist in Figur 5 nicht dargestellt) kann erreicht werden, dass zwischen dem ersten Submodulanschluss 512 und dem zweiten Submodulanschluss 515 entweder die Spannung des Energiespeichers 510 ausgegeben wird oder keine Spannung ausgegeben wird. Im Zusammenwirken der Submodule der einzelnen Phasenmodulzweige kann so die jeweils gewünschte Ausgangsspannung des Stromrichters erzeugt werden.

In Figur 6 ist ein weiteres Ausführungsbeispiel für ein Submodul 601 dargestellt. Bei diesem Submodul kann es sich beispielsweise um das Submodul 1_n handeln. Neben dem bereits aus Figur 5 bekannten ersten Halbleiterventil 502, zweiten Halbleiterventil 506, erster Diode 504, zweiter Diode 508 und Energiespeicher 510 weist das in Figur 6 dargestellte Submodul 601 ein drittes abschaltbares Halbleiterventil 602 mit einer antiparallel geschalteten dritten Diode 604 sowie ein viertes abschaltbares Halbleiterventil 606 mit einer vierten antiparallel geschalteten Diode 608 auf. Im Unterschied zur Schaltung der Figur 4 ist der zweite Submodulanschluss 615 nicht mit dem zweiten Halbleiterventil 506 verbunden, sondern mit einem Mittelpunkt einer elektrischen Reihenschaltung aus dem dritten Halbleiterventil 602 und dem vierten Halbleiterventil 606. Die in Figur 6 dargestellte Schaltung 601 stellt ein sogenanntes Vollbrückenmodul dar. Dieses Vollbrückenmodul 601 zeichnet sich dadurch aus, dass bei entsprechender Ansteuerung der vier Halbleiterventile zwischen dem ersten Submodulanschluss 512 und dem zweiten Submodulanschluss 615 wahlweise entweder die positive Spannung des Energiespeichers 510, die negative Spannung des Energiespeichers 510 oder eine Spannung des Wertes Null ausgegeben werden kann. Somit kann also mittels des Vollbrückenmoduls 501 die Polarität der Ausgangsspannung umgekehrt werden.

Die Submodule des Stromrichters 3 können entweder nur Halbbrückenmodule 501, nur Vollbrückenmodule 601 oder auch Halbbrückenmodule 501 und Vollbrückenmodule 601 aufweisen.

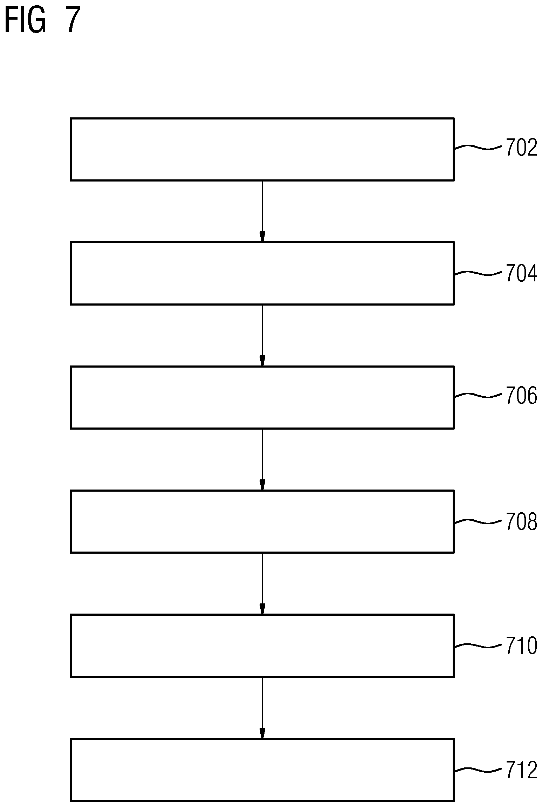

In Figur 7 ist ein beispielhafter Ablauf des Verfahrens zum Beeinflussen von Betriebsbedingungen des Stromrichters 3 dargestellt. Dabei laufen folgende Verfahrensschritte ab:

| | |
|---|---|
| 702 | Beeinflussen der Konzentrationen der Bestandteile des gasförmigen Stoffs |
| 704 | Erhöhen des Drucks des gasförmigen Stoffs |
| 706 | Beeinflussen der Menge des Wasserdampfs in dem gasförmigen Stoff (Beeinflussen der relativen Feuchtigkeit des gasförmigen Stoffs) |
| 708 | Beeinflussen der Temperatur des gasförmigen Stoffs |
| 710 | Einschalten des Stromrichters |
| 712 | Halten der Konzentrationen der Bestandteile des gasförmigen Stoffes, des Druck, der Menge des Wasserdampfs und/oder der Temperatur auf dem erreichten Wert |

Dabei können einer oder mehrere der genannten Verfahrensschritte (insbesondere einer oder mehrere der Verfahrensschritte 702, 704, 706 und 708) weggelassen werden.

In dem ersten Verfahrensschritt 702 werden die Konzentrationen der Bestandteile des gasförmigen Stoffes 88 beeinflusst. Dies geschieht beispielsweise durch die Gaszuführungseinrichtung 68, welche ausgewählte Gase in die Innenräume der Gehäuse 35, 37, 39, 41, 43 und 45 abgibt. In dem folgenden Verfahrensschritt 704 wird der Druck des gasförmigen Stoffes 88 in den Innenräumen der Gehäuse 35, 37, 39, 41, 43 und 45 erhöht. Dies erfolgt beispielsweise durch die Druckerhöhungseinrichtung 53. Im darauffolgenden Verfahrensschritt 706 wird die Menge des Wasserdampfs in dem gasförmigen Stoff 88 (in den Innenräumen der Gehäuse 35, 37, 39, 41, 43 und 45) beeinflusst. Mit anderen Worten wird die Feuchtigkeit des gasförmigen Stoffes 88 beeinflusst. Dies geschieht beispielsweise durch die Befeuchtungseinrichtung 56 und durch die Entfeuchtungseinrichtung 59. Im darauffolgenden Verfahrensschritt 708 wird die Temperatur des gasförmigen Stoffes 88 beeinflusst. Diese Temperaturbeeinflussung erfolgt beispielsweise durch die Heizeinrichtung 62 und die Kühleinrichtung 65. Im darauffolgenden Schritt 710 wird der Stromrichter eingeschaltet. Daraufhin beginnt der Stromrichter 3 zu arbeiten.

Im nächsten Verfahrensschritt 712 werden die Konzentrationen der Bestandteile des gasförmigen Stoffes 88, der Druck des gasförmigen Stoffes 88, die Menge des Wasserdampfs in dem gasförmigen Stoff 88 und/oder die Temperatur des gasförmigen Stoffes 88 auf dem jeweils gewünschten (vorgewählten) Wert gehalten. Dies kann beispielsweise mit einer oder mehreren Regelungen erfolgen. Dadurch werden diese Größen (Konzentrationen der Bestandteile des gasförmigen Stoffes 88, Druck, Menge des Wasserdampfs in dem gasförmigen Stoff 88 und/oder Temperatur) auf dem jeweils gewünschten Wert gehalten, solange der Stromrichter in Betrieb ist.

Das Verfahren kann so ausgestaltet sein, dass der gasförmige Stoff Luft aufweist. Das Verfahren kann auch so ablaufen, dass der gasförmige Stoff diejenigen Gase aufweist, die in Luft enthalten sind, und die Konzentrationen von mindestens zwei dieser Gase des gasförmigen Stoffes verändert werden gegenüber den Konzentrationen der jeweiligen Gase in Luft.

Die beschriebene Anordnung und das beschriebene Verfahren lassen sich besonders nutzbringend dort einsetzen, wo Platz bzw. benötigter Raum sehr teuer ist. Das ist beispielsweise auf Offshore-Anlagen (also zum Beispiel auf im Meer stehenden Plattformen oder bei im Meer stehenden Türmen) der Fall. Wenn an solchen Orten Stromrichter installiert werden sollen, ist es außerordentlich kostensparend, wenn der benötigte Platz/Raum für die Installation solcher Stromrichter verringert werden kann. Dies kann vorteilhafterweise durch die beschriebene Anordnung bzw. das beschriebene Verfahren erfolgen. Die Kosten der gegenüber einer herkömmlichen Luftisolierung zusätzlich benötigten Elemente (Druckerhöhungseinrichtung, Befeuchtungseinrichtung, Heizeinrichtung usw.) sind in vielen Fällen weitaus geringer als die eingesparten Kosten für den weniger benötigten Platz/Raum für den Stromrichter. Somit ergibt sich eine Anordnung bzw. ein Verfahren, mit denen die Kosten für Stromrichter deutlich gesenkt werden können. Bei einer zukünftigen weiteren Erhöhung der Betriebsspannung von Stromrichtern könnte die erreichbare Kostensenkung sogar noch stärker ins Gewicht fallen.

Bei den beschriebenen Ausführungsbeispielen ist besonders vorteilhaft, dass der dreiphasige Stromrichter mittels der sechs Gehäuse 35, 37, 39, 41, 43 und 45 konstruktiv in sechs relativ unabhängige Stromrichterzweige aufgeteilt ist. Dies ist dadurch erreicht, dass jeder Stromrichterzweig in einem eigenen Gehäuse untergebracht ist. Die einzelnen Gehäuse können beispielsweise jeweils als rohrförmige Gehäuse ausgestaltet sein, welche an ihren Enden abgerundet sind und mit druckdichten Durchführungen für die elektrischen Verbindungen (Hochspannungsverbindungen und Signalverbindungen) versehen sind. Diese sechs Gehäuse sind jeweils eigenstabil und lassen sich vorteilhaft leicht am gewünschten Ort des Stromrichters installieren (beispielsweise an einer Offshore-Plattform, wenn der Stromrichter für einen auf einem Meer angeordneten Windpark vorgesehen ist). Vorteilhafterweise kann jedes der sechs Gehäuse in jeweils einem Pfahl ("Bein") einer solchen Plattform angeordnet werden. Dies ist deshalb vorteilhaft, weil dann für die einzelnen Phasenmodulzweige kein zusätzlicher Platz auf der Plattform benötigt wird und der sowieso vorhandene Platz in den Pfählen ("Beinen") sinnvoll genutzt werden kann.

Es wurde eine Anordnung sowie ein Verfahren beschrieben, mit denen der für Stromrichter benötigte Platz deutlich verringert werden kann.

## Patentansprüche

1. Anordnung (1) mit einem Stromrichter (3),
- der mindestens ein Phasenmodul (15, 24, 31), einen Wechselspannungsanschluss (5), einen ersten Gleichspannungsanschluss (16) und einen zweiten Gleichspannungsanschluss (17) aufweist, wobei zwischen dem Wechselspannungsanschluss (5) und dem ersten Gleichspannungsanschluss (16) ein erster Phasenmodulzweig (11) ausgebildet ist, wobei zwischen dem Wechselspannungsanschluss (5) und dem zweiten Gleichspannungsanschluss (17) ein zweiter Phasenmodulzweig (13) ausgebildet ist, wobei
- die Anordnung eine Gaszuführeinrichtung (68) aufweist, **dadurch gekennzeichnet, dass**
- jeder Phasenmodulzweig mindestens zwei Submodule (1_1, 1_2, 1_3, 2_1, 2_2, 2_3) aufweist, wobei
- die Submodule (1_1, 1_2, 1_3) des ersten Phasenmodulzweigs (11) von einem ersten Gehäuse (35) umgeben sind, welches mit einem gasförmigen Stoff (88) gefüllt ist, und
- die Submodule (2_1, 2_2, 2_3) des zweiten Phasenmodulzweigs (13) von einem zweiten Gehäuse (37) umgeben sind, welches mit dem gasförmigen Stoff (88) gefüllt ist,
- der gasförmige Stoff (88) diejenigen Gase aufweist, die in Luft enthalten sind, wobei die Konzentrationen von mindestens zwei dieser Gase des gasförmigen Stoffs (88) sich unterscheiden von den Konzentrationen der jeweiligen Gase in Luft, so dass die Durchschlagfestigkeit des gasförmigen Stoffs vergrößert ist, wobei der gasförmige Stoff (88) Stickstoff und Kohlendioxid aufweist, wobei die Konzentration des Stickstoffs und die Konzentration des Kohlendioxids erhöht ist gegenüber der jeweiligen Konzentration des Stickstoffs und des Kohlendioxids in Luft,
- die Gaszuführeinrichtung (68) einen oder mehrere Gasspeicher aufweist, und die Gaszuführeinrichtung (68) eingerichtet ist, in diesem Gasspeicher gespeichertes Gas in den Innenraum (90) der Gehäuse (35, 37) abzugeben, und
- die Anordnung eine Regelung aufweist, die eingerichtet ist, die Konzentrationen von Bestandteilen des gasförmigen Stoffes (88) auf einem jeweils vorgewählten Wert zu halten, solange der Stromrichter in Betrieb ist.

2. Anordnung nach Anspruch 1,
**dadurch gekennzeichnet, dass**
- der Stromrichter mehrere Phasenmodule, insbesondere drei Phasenmodule (15, 24, 31), aufweist.

3. Anordnung nach Anspruch 1 oder 2,
**dadurch gekennzeichnet, dass**
- die Submodule Halbbrückenmodule (501) sind, welche jeweils zwei abschaltbare Halbleiterventile (502,506) mit jeweils einer antiparallel geschalteten Diode (504, 508) und einen Energiespeicher (510) aufweisen, und/oder die Submodule Vollbrückenmodule (601) sind, welche jeweils vier abschaltbare Halbleiterventile (502, 506, 602, 606) mit jeweils einer antiparallel geschalteten Diode (504, 508, 604, 608) und einen Energiespeicher (510) aufweisen.

4. Anordnung nach einem der vorhergehenden Ansprüche,
**gekennzeichnet durch**
- eine Verbindungsleitung (305) zum Verbinden des gasförmigen Stoffs (88) des ersten Gehäuses (35) mit dem gasförmigen Stoff (88) des zweiten Gehäuses (37).

5. Anordnung nach einem der vorhergehenden Ansprüche,
**gekennzeichnet durch**
- eine Absperreinrichtung (307) zum Trennen des gasförmigen Stoffs (88) des ersten Gehäuses (35) von dem gasförmigen Stoff (88) des zweiten Gehäuses (37).

6. Anordnung nach einem der vorhergehenden Ansprüche,
**gekennzeichnet durch**
- eine Verbindungsleitung (272) zum Verbinden des ersten Gehäuses (35) eines ersten Phasenmoduls (15) mit einem ersten Gehäuse (39) eines zweiten Phasenmoduls (24).

7. Anordnung nach einem der vorhergehenden Ansprüche,
**dadurch gekennzeichnet, dass**
- eine elektrische Verbindung (204) zwischen zwei Phasenmodulzweigen (11, 18) innerhalb einer Verbindungsleitung (272) zwischen den beiden Phasenmodulzweigen (11, 18) verläuft.

8. Anordnung nach einem der vorhergehenden Ansprüche,
**dadurch gekennzeichnet, dass**
- die Anordnung eine Druckerhöhungseinrichtung (53) zum Erhöhen des Drucks des gasförmigen Stoffes (88) aufweist.

9. Anordnung nach einem der vorhergehenden Ansprüche,
**dadurch gekennzeichnet, dass**
- die Anordnung eine Befeuchtungseinrichtung (56) zum Vergrößern der Menge von in den Gehäusen (35, 37, 39, 41, 43, 45) eingeschlossenem Wasserdampf und/oder eine Entfeuchtungseinrichtung (59) zum Verringern der Menge des in den Gehäusen (35, 37, 39, 41, 43, 45) eingeschlossenen Wasserdampfs aufweist.

10. Anordnung nach einem der vorhergehenden Ansprüche,
**dadurch gekennzeichnet, dass**
- die Anordnung eine Heizeinrichtung (62) zum Erhöhen der Temperatur in den Gehäusen (35, 37, 39, 41, 43, 45) und/oder eine Kühleinrichtung (65) zum Verringern der Temperatur in den Gehäusen (35, 37, 39, 41, 43, 45) aufweist.

11. Anordnung nach einem der vorhergehenden Ansprüche,
**dadurch gekennzeichnet, dass**
- der gasförmige Stoff (88) Luft aufweist.

12. Anordnung nach einem der Ansprüche 8 bis 11,
**dadurch gekennzeichnet, dass**
- die Druckerhöhungseinrichtung (53), die Befeuchtungseinrichtung (56), die Entfeuchtungseinrichtung (59), die Heizeinrichtung (62) und/oder die Kühleinrichtung (65) mittels mindestens einer Verbindungsleitung (50, 72, 76, 80, 84) mit den Gehäusen (35, 37, 39, 41, 43, 45) verbunden ist.

13. Verfahren zum Beeinflussen von Betriebsbedingungen eines Stromrichters (3), der mindestens ein Phasenmodul (15, 24, 31), einen Wechselspannungsanschluss (5), einen ersten Gleichspannungsanschluss (16) und einen zweiten Gleichspannungsanschluss (17) aufweist, wobei zwischen dem Wechselspannungsanschluss (5) und dem ersten Gleichspannungsanschluss (16) ein erster Phasenmodulzweig (11) ausgebildet ist, zwischen dem Wechselspannungsanschluss (5) und dem zweiten Gleichspannungsanschluss (17) ein zweiter Phasenmodulzweig (13) ausgebildet ist, jeder Phasenmodulzweig mindestens zwei Submodule (1_1, 1_2, 1_3, 2_1, 2_2, 2_3) aufweist, die Submodule (1_1, 1_2, 1_3) des ersten Phasenmodulzweigs (11) von einem ersten Gehäuse (35) umgeben sind, die Submodule (2_1, 2_2, 2_3) des zweiten Phasenmodulzweigs (13) von einem zweiten Gehäuse (37) umgeben sind und das erste Gehäuse (35) und das zweite Gehäuse (37) mit einem gasförmigen Stoff (88) gefüllt sind, wobei der gasförmige Stoff (88) Luft aufweist, wobei bei dem Verfahren
- der Druck des gasförmigen Stoffs (88) gegenüber dem außerhalb der Gehäuse herrschenden Außendruck erhöht wird (704), so dass die Durchschlagfestigkeit des gasförmigen Stoffs vergrößert wird, und
- in einem Gasspeicher gespeichertes Gas in den Innenraum (90) der Gehäuse (35, 37) abgegeben wird, wodurch die Konzentrationen von mindestens zwei der Gase des gasförmigen Stoffs (88) sich unterscheiden von den Konzentrationen der jeweiligen Gase in Luft, so dass die Durchschlagfestigkeit des gasförmigen Stoffs nochmals vergrößert wird, wobei
- der gasförmige Stoff (88) Stickstoff und Kohlendioxid aufweist, und die Konzentration des Stickstoffs und die Konzentration des Kohlendioxids erhöht wird gegenüber der jeweiligen Konzentration des Stickstoffs und des Kohlendioxids in Luft (702), und
- die Konzentrationen von Bestandteilen des gasförmigen Stoffes (88) mit einer Regelung auf einem jeweils vorgewählten Wert gehalten werden, solange der Stromrichter in Betrieb ist.

14. Verfahren nach Anspruch 13,
**dadurch gekennzeichnet, dass**
- die Menge von in dem gasförmigen Stoff (88) enthaltenem Wasserdampf beeinflusst wird (706).

15. Verfahren nach Anspruch 13 oder 14,
**dadurch gekennzeichnet, dass**
- die Temperatur des gasförmigen Stoffes (88) auf einen Wert innerhalb eines vorgegebenen Temperaturbereichs eingestellt wird (708).

## Claims

1. Arrangement (1) having a power converter (3)
- which has at least one phase module (15, 24, 31), an AC voltage connection (5), a first DC voltage connection (16) and a second DC voltage connection (17), wherein a first phase module branch (11) is formed between the AC voltage connection (5) and the first DC voltage connection (16), wherein a second phase module branch (13) is formed between the AC voltage connection (5) and the second DC voltage connection (17), wherein
- the arrangement has a gas supply device (68),
**characterized in that**
- each phase module branch has at least two submodules (1_1, 1_2, 1_3, 2_1, 2_2, 2_3), wherein
- the submodules (1_1, 1_2, 1_3) of the first phase module branch (11) are surrounded by a first housing (35) which is filled with a gaseous substance (88), and
- the submodules (2_1, 2_2, 2_3) of the second phase module branch (13) are surrounded by a second housing (37) which is filled with the gaseous substance (88),
- the gaseous substance (88) has those gases which are included in air, wherein the concentrations of at least two of these gases of the gaseous substance (88) differ from the concentrations of the respective gases in air, with the result that the dielectric strength of the gaseous substance is increased, wherein the gaseous substance (88) has nitrogen and carbon dioxide, wherein the nitrogen concentration and the carbon dioxide concentration are increased in comparison with the respective nitrogen and carbon dioxide concentration in air,
- the gas supply device (68) has one or more gas stores, and the gas supply device (68) is configured to deliver gas stored in this gas store to the interior (90) of the housings (35, 37), and
- the arrangement has a controller which is configured to keep the concentrations of constituent parts of the gaseous substance (88) at a respective preselected value as long as the power converter is operating.

2. Arrangement according to Claim 1,
**characterized in that**
- the power converter has a plurality of phase modules, in particular three phase modules (15, 24, 31).

3. Arrangement according to Claim 1 or 2,
**characterized in that**
- the submodules are half-bridge modules (501) each having two disconnectable semiconductor valves (502, 506) each with a diode (504, 508) reverse-connected in parallel and an energy store (510), and/or the submodules are full-bridge modules (601) each having four disconnectable semiconductor valves (502, 506, 602, 606) each with a diode (504, 508, 604, 608) reverse-connected in parallel and an energy store (510).

4. Arrangement according to one of the preceding claims,
**characterized by**
- a connecting line (305) for connecting the gaseous substance (88) of the first housing (35) to the gaseous substance (88) of the second housing (37).

5. Arrangement according to one of the preceding claims,
**characterized by**
- a shut-off device (307) for separating the gaseous substance (88) of the first housing (35) from the gaseous substance (88) of the second housing (37).

6. Arrangement according to one of the preceding claims,
**characterized by**
- a connecting line (272) for connecting the first housing (35) of a first phase module (15) to a first housing (39) of a second phase module (24).

7. Arrangement according to one of the preceding claims,
**characterized in that**
- an electrical connection (204) between two phase module branches (11, 18) runs within a connecting line (272) between the two phase module branches (11, 18).

8. Arrangement according to one of the preceding claims,
**characterized in that**
- the arrangement has a pressure-increasing device (53) for increasing the pressure of the gaseous substance (88).

9. Arrangement according to one of the preceding claims,
**characterized in that**
- the arrangement has a humidification device (56) for increasing the amount of water vapour enclosed in the housings (35, 37, 39, 41, 43, 45) and/or a dehumidification device (59) for reducing the amount of water vapour enclosed in the housings (35, 37, 39, 41, 43, 45).

10. Arrangement according to one of the preceding claims,
**characterized in that**
- the arrangement has a heating device (62) for increasing the temperature in the housings (35, 37, 39, 41, 43, 45) and/or a cooling device (65) for reducing the temperature in the housings (35, 37, 39, 41, 43, 45).

11. Arrangement according to one of the preceding claims,
**characterized in that**
- the gaseous substance (88) has air.

12. Arrangement according to one of Claims 8 to 11,
**characterized in that**
- the pressure-increasing device (53), the humidification device (56), the dehumidification device (59), the heating device (62) and/or the cooling device (65) is/are connected to the housings (35, 37, 39, 41, 43, 45) by means of at least one connecting line (50, 72, 76, 80, 84).

13. Method for influencing operating conditions of a power converter (3) which has at least one phase module (15, 24, 31), an AC voltage connection (5), a first DC voltage connection (16) and a second DC voltage connection (17), wherein a first phase module branch (11) is formed between the AC voltage connection (5) and the first DC voltage connection (16), a second phase module branch (13) is formed between the AC voltage connection (5) and the second DC voltage connection (17), each phase module branch has at least two submodules (1_1, 1_2, 1_3, 2_1, 2_2, 2_3), the submodules (1_1, 1_2, 1_3) of the first phase module branch (11) are surrounded by a first housing (35), the submodules (2_1, 2_2, 2_3) of the second phase module branch (13) are surrounded by a second housing (37) and the first housing (35) and the second housing (37) are filled with a gaseous substance (88), wherein the gaseous substance (88) has air, wherein, in the method,
- the pressure of the gaseous substance (88) is increased (704) in comparison with the external pressure prevailing outside the housings, with the result that the dielectric strength of the gaseous substance is increased, and
- gas stored in a gas store is delivered to the interior (90) of the housings (35, 37), as a result of which the concentrations of at least two of the gases of the gaseous substance (88) differ from the concentrations of the respective gases in air, with the result that the dielectric strength of the gaseous substance is increased again, wherein
- the gaseous substance (88) has nitrogen and carbon dioxide, and the nitrogen concentration and the carbon dioxide concentration are increased (702) in comparison with the respective nitrogen and carbon dioxide concentration in air, and
- the concentrations of constituent parts of the gaseous substance (88) are held at a respective preselected value using a controller as long as the power converter is operating.

14. Method according to Claim 13,
**characterized in that**
- the amount of water vapour contained in the gaseous substance (88) is influenced (706).

15. Method according to Claim 13 or 14,
**characterized in that**
- the temperature of the gaseous substance (88) is set (708) to a value within a predefined temperature range.

## Revendications

1. Système (1) comprenant un convertisseur (3),
- qui a au moins un module (15, 24, 31) de phase, une borne (5) pour la tension alternative, une première borne (16) pour la tension continue et une deuxième borne (17) pour la tension continue, dans lequel une première branche (11) du module de phase est constituée entre la borne (5) pour la tension alternative et la première borne (16) pour la tension continue, dans lequel une deuxième branche (13) du module de phase est constituée entre la borne (5) pour la tension alternative et la deuxième borne (17) pour la tension continue, dans lequel
- le système a un dispositif (68) d'apport de gaz,
**caractérisé en ce que**
- chaque branche de module de phase a au moins deux sous-modules (1_1, 1_2, 1_3, 2_1, 2_2, 2_3), dans lequel
- les sous-modules (1_1, 1_2, 1_3) de la première branche (11) de module de phase sont entourés d'une première enveloppe (35), qui est remplie d'une substance (88) gazeuse, et
- les sous-modules (2_1, 2_2, 2_3) de la deuxième branche (13) de module de phase sont entourés d'une deuxième enveloppe (37), qui est remplie de la substance (88) gazeuse,
- la substance (88) gazeuse a les gaz, qui sont contenus dans l'air, dans lequel les concentrations d'au moins deux de ces gaz de la substance (88) gazeuse sont différentes des concentrations des gaz respectifs dans l'air, de manière à augmenter la rigidité diélectrique de la substance gazeuse, la substance (88) gazeuse comportant de l'azote et du dioxyde de carbone, la concentration de l'azote et la concentration du dioxyde de carbone étant augmentée par rapport à la concentration respective de l'azote et du dioxyde de carbone dans l'air,
- le dispositif (68) d'apport de gaz a un ou plusieurs accumulateurs de gaz et le dispositif (68) d'apport de gaz est conçu pour céder du gaz accumulé dans cet accumulateur de gaz à l'espace (90) intérieur des enveloppes (35, 37), et
- le système a une régulation, qui est conçue pour maintenir les concentrations des constituants de la substance (88) gazeuse à une valeur respective sélectionnée à l'avance, tant que le convertisseur est en fonctionnement.

2. Système suivant la revendication 1,
**caractérisé en ce que**
- le convertisseur a plusieurs modules de phase, notamment trois modules (15, 24, 31) de phase.

3. Système suivant la revendication 1 ou 2,
**caractérisé en ce que**
- les sous-modules sont des modules (501) à demi-pont, qui ont chacun deux soupapes (502, 506) à semiconducteurs pouvant être ouvertes ayant respectivement une diode (504, 508) montée tête bêche et un accumulateur (510) d'énergie, et/ou les sous-modules sont des modules (601) à pont complet, qui ont chacun quatre soupapes (502, 506, 602, 606) à semiconducteurs pouvant être ouvertes ayant chacune une diode (504, 508, 604, 608) montée tête bêche et un accumulateur (510) d'énergie.

4. Système suivant l'une des revendications précédentes,
**caractérisé par**
- une ligne (305) de communication pour mettre en communication la substance (88) gazeuse de la première enveloppe (35) avec la substance (88) gazeuse de la deuxième enveloppe (37).

5. Système suivant l'une des revendications précédentes,
**caractérisé par**
- un dispositif (307) de barrage pour séparer la substance (88) gazeuse de la première enveloppe (35) de la substance (88) gazeuse de la deuxième enveloppe (37).

6. Système suivant l'une des revendications précédentes,
**caractérisé par**
- une ligne (272) de liaison pour la liaison de la première enveloppe (35) d'un premier module (15) de phase à une première enveloppe (39) d'un deuxième module (24) de phase.

7. Système suivant l'une des revendications précédentes,
**caractérisé en ce que**
- une liaison (204) électrique s'étend entre deux branches (11, 18) de module de phase dans une ligne (272) de liaison entre les deux branches (11, 18) de module de phase.

8. Système suivant l'une des revendications précédentes,
**caractérisé en ce que**
- le système a un dispositif (53) d'élévation de la pression pour élever la pression de la substance (88) gazeuse.

9. Système suivant l'une des revendications précédentes,
**caractérisé en ce que**
- le système a un dispositif (56) d'humidification pour augmenter la quantité de vapeur d'eau enfermée dans les enveloppes (35, 37, 39, 41, 43, 45) et/ou un dispositif (59) de déshumidification pour diminuer la quantité de la vapeur d'eau enfermée dans les enveloppes (35, 37, 39, 41, 43, 45).

10. Système suivant l'une des revendications précédentes,
**caractérisé en ce que**
- le système a un dispositif (62) de chauffage pour élever la température dans les enveloppes (35, 37, 39, 41, 43, 45) et/ou un dispositif (65) de refroidissement pour abaisser la température dans les enveloppes (35, 37, 39, 41, 43, 45).

11. Système suivant l'une des revendications précédentes,
**caractérisé en ce que**
- la substance (88) gazeuse a de l'air.

12. Système suivant l'une des revendications 8 à 11,
**caractérisé en ce que**
- le dispositif (53) d'élévation de la pression, le dispositif (56) d'humidification, le dispositif (59) de déshumidification, le dispositif (62) de chauffage et/ou le dispositif (65) de refroidissement communiquent avec les enveloppes (35, 37, 39, 41, 43, 45) au moyen d'au moins une ligne (50, 72, 76, 80, 84) de communication.

13. Procédé pour influencer les conditions de fonctionnement d'un convertisseur (3), qui a au moins un module (15, 24, 31) de phase, une borne (5) pour la tension alternative, une première borne (16) pour la tension continue et une deuxième borne (17) pour la tension continue, dans lequel une première branche (11) du module de phase est constituée entre la borne (5) pour la tension alternative et la première borne (16) pour la tension continue, dans lequel une deuxième branche (13) du module de phase est constituée entre la borne (5) pour la tension alternative et la deuxième borne (17) pour la tension continue, dans lequel chaque branche de module de phase a au moins deux sous-modules (1_1, 1_2, 1_3, 2_1, 2_2, 2_3), dans lequel les sous-modules (1_1, 1_2, 1_3) de la première branche (11) de module de phase sont entourés d'une première enveloppe (35), qui est remplie d'une substance (88) gazeuse, et les sous-modules (2_1, 2_2, 2_3) de la deuxième branche (13) de module de phase sont entourés d'une deuxième enveloppe (37) et la première enveloppe (35) et la deuxième enveloppe (37) sont remplies d'une substance (88) gazeuse, dans lequel la substance (88) gazeuse a de l'air, dans lequel dans le procédé
- on élève (704) la pression de la substance (88) gazeuse par rapport à la pression extérieure régnant à l'extérieur des enveloppes, de manière à augmenter la rigidité diélectrique de la substance gazeuse, et
- on cède du gaz, accumulé dans un accumulateur de gaz, à l'espace (90) intérieur des enveloppes (35, 37), grâce à quoi les concentrations d'au moins deux des gaz de la substance (88) gazeuse se différencient des concentrations des gaz respectifs dans l'air, de manière à augmenter la rigidité diélectrique de la substance gazeuse, dans lequel
- la substance (88) gazeuse comprend de l'azote et du dioxyde de carbone et on augmente la concentration de l'azote et la concentration du dioxyde de carbone par rapport à la concentration respective de l'azote et du dioxyde de carbone dans l'air (702), et
- on maintient les concentrations des constituants de la substance (88) gazeuse par une régulation à une valeur respective pouvant être sélectionnée à l'avance, tant que le convertisseur est en fonctionnement.

14. Procédé suivant la revendication 13,
**caractérisé en ce que**
- l'on influence (706) la quantité de vapeur d'eau contenue dans la substance (88) gazeuse.

15. Procédé suivant la revendication 13 ou 14,
**caractérisé en ce que**
- l'on règle (708) la température de la substance (88) gazeuse à une valeur dans une plage de températures donnée à l'avance.
